# EUROPEAN PATENT SPECIFICATION

(11) **EP 2 677 816 B1**
(45) Date of publication and mention of the grant of the patent: **09.03.2016**
(21) Application number: 11864319.6
(22) Date of filing: 21.09.2011
(51) Int. Cl.: H04W 52/02, H04B 1/04

(54) **METHOD AND SYSTEM FOR REDUCING POWER DISSIPATION IN TIME DIVISION DUAL (TDD) SYSTEM**
VERFAHREN UND SYSTEM ZUR REDUZIERUNG DER VERLUSTLEISTUNG IN EINEM ZEITMULTIPLEX-DUALSYSTEM (TDD)
PROCÉDÉ ET SYSTÈME DE RÉDUCTION DE LA DISSIPATION DE PUISSANCE DANS UN SYSTÈME DE DUPLEXAGE PAR RÉPARTITION DANS LE TEMPS (TDD)

(30) Priority: 29.04.2011 CN 201110111448
(43) Date of publication of application: 25.12.2013
(73) Proprietor: ZTE Corporation, Shenzhen, Guangdong 518057 (CN)
(72) Inventor: ZHOU, Min, Guangdong 518057 (CN); LIU, Yang, Guangdong 518057 (CN)
(74) Representative: Tellefsen, Jens J.
(86) International application number: PCT/CN2011/079944
(87) International publication number: WO 2012/145987

(56) References cited:
- CN-A- 101 218 772
- CN-A- 101 741 774
- CN-A- 101 741 774
- JP-A- 2008 219 401
- US-A1- 2004 185 908

## Description

### Technical Field

The present document relates to the field of power consumption of a Time Division Dual (TDD) system, and in particular, to a method and system for reducing the power consumption of the TDD system.

### Background of the Related Art

In the existing wireless communication systems, power consumption has become one of increasingly critical problems, and various systems perform optimization processing on the problem as far as possible.

For the TDD system, the purpose of reducing the power consumption is achieved by controlling power of various parts of the Remote Radio Unit (RRU) according to the time slots. The power amplifiers occupies majority of the power consumption of the system, and currently, the efficiency of the power amplifiers is proposed based on rated power; however, the power amplifiers work in a fallback state most of the time, but at the time the efficiency of power amplifiers is very low, especially at night when there is generally no active users.

The features of the preamble of the independent claims are known from CN101741774A.

### Summary of the Invention

The present document provides a method and system for reducing power consumption in a TDD system as defined in the independent claims, to solve the problems of the high power consumption and the low efficiency of power amplifiers when the existing TDD system is in a fallback state.

A method for reducing power consumption in a TDD system, comprising:
a scheduling system calculating the number of symbols required in time domain according to the number of users in a cell, determining a TDD time slot configuration and forwarding the TDD time slot configuration to an RRU through a base band unit (BBU).

Wherein, the method further comprises: the RRU generating a TDD control signal for the cell according to the TDD time slot configuration.

Wherein, from 0 to the number of full symbols, it is to divide into at least two threshold ranges;
said determining a TDD time slot configuration comprises:
determining a threshold range where the number of symbols required in the time domain is located, using the TDD time slot configuration corresponding to that threshold range as a finally determined TDD time slot configuration to forward to a BBU, wherein the TDD time slot configuration corresponding to that threshold range is not less than a TDD time slot configuration corresponding to a maximum number of symbols in the threshold range.

Wherein, said determining a TDD time slot configuration comprises: using the TDD time slot configuration corresponding to the number of symbols required in the time domain as a finally determined TDD time slot configuration to forward to the BBU.

Wherein, before the scheduling system calculates the number of symbols required in the time domain according to the number of users in a cell, whether a triggering condition is satisfied is determined, and if it is satisfied, the number of symbols required in the time domain is calculated according to the number of users in the cell.

Wherein, the triggering condition is that: the number of users in the cell changes; or an amplitude of the change of the number of users in the cell exceeds a preset threshold; or a determination period expires.

Wherein, the determination period is a length of a time division multiplexing frame generated by the system.

Wherein, said forwarding the TDD time slot configuration to the RRU through a BBU comprises: the scheduling system forwarding the TDD time slot configuration to the BBU, and the BBU inserting the TDD time slot configuration into a media stream to transmit to the RRU.

A system for reducing power consumption in a TDD system, comprising: a calculation module, a configuration module, and a forwarding module, wherein,
the calculation module is configured to calculate a number of symbols required in time domain according to the number of users in a cell;
the configuration module is configured to determine a TDD time slot configuration according to the number of symbols required in the time domain; and
the forwarding module is configured to forward the TDD time slot configuration to an RRU.
wherein, the configuration module is configured to, from 0 to a number of full symbols, divide into at least two threshold ranges; and determine a threshold range where the number of symbols required in the time domain is located, use the TDD time slot configuration corresponding to the threshold range as a finally determined TDD time slot configuration to forward to a BBU, wherein the TDD time slot configuration corresponding to the threshold range not is less than a TDD time slot configuration corresponding to a maximum number of symbols in the threshold range.

A method for reducing power consumption in a TDD system, comprising:
a scheduling system calculating the number of symbols required in time domain according to the number of users in a cell, determining a TDD time slot configuration according to the number of symbols required in the time domain and forwarding the TDD time slot configuration to an RRU through a BBU.

The method further comprises: the RRU generating a TDD control signal for the cell according to the TDD time slot configuration.

Wherein, the step of determining a TDD time slot configuration according to the number of symbols required in the time domain comprises:
from 0 to a number of full symbols, dividing into at least two threshold ranges;
determining a threshold range where the number of symbols required in the time domain is located, using the TDD time slot configuration corresponding to the threshold range as a finally determined TDD time slot configuration, wherein the TDD time slot configuration corresponding to the threshold range is not less than a TDD time slot configuration corresponding to the maximum number of symbols in the threshold range.

Wherein, the step of determining a TDD time slot configuration according to the number of symbols required in the time domain comprises:
using the TDD time slot configuration corresponding to the number of symbols required in the time domain as a finally determined TDD time slot configuration.

The method further comprises:
before the scheduling system calculates the number of symbols required in the time domain according to the number of users in a cell, determining whether a triggering condition is satisfied, and if it is satisfied, calculating the number of symbols required in the time domain according to the number of users in the cell.

Wherein, the triggering condition is that:
the number of users in the cell changes; or
an amplitude of the change of the number of users in the cell exceeds a preset threshold; or a determination period expires.

Wherein, the determination period is a length of a time division multiplexing frame generated by the system.
wherein, the step of forwarding the TDD time slot configuration to the RRU through a BBU comprising:
the scheduling system forwarding the TDD time slot configuration to the BBU, and the BBU inserting the TDD time slot configuration into a media stream to transmit to the RRU.

A system for reducing power consumption in a TDD system, comprising: a calculation module, a configuration module, and a forwarding module, wherein,
the calculation module is configured to calculate the number of symbols required in time domain according to the number of users in a cell;
the configuration module is configured to determine a TDD time slot configuration according to the number of symbols required in the time domain; and
the forwarding module is configured to forward the TDD time slot configuration to an RRU through a BBU.

Wherein, the configuration module is configured to determine the TDD time slot configuration by the following way:
from 0 to the number of full symbols, dividing into at least two threshold ranges; and determining a threshold range where the number of symbols required in the time domain is located, using the TDD time slot configuration corresponding to the threshold range as a finally determined TDD time slot configuration, wherein the TDD time slot configuration corresponding to the threshold range is not less than a TDD time slot configuration corresponding to the maximum number of symbols in the threshold range.
wherein, the configuration module is configured to determine the TDD time slot configuration by the following way:
   using the TDD time slot configuration corresponding to the number of symbols required in the time domain as a finally determined TDD time slot configuration.

The system further comprises: a determination module,
wherein, the determination module is configured to: before calculating the number of symbols required in the time domain according to the number of users in a cell, determine whether a triggering condition is satisfied, and if it is satisfied, notify the calculation module to calculate the number of symbols required in the time domain according to the number of users in the cell.
wherein, the triggering condition is that:
the number of users in the cell changes; or
an amplitude of the change of the number of users in the cell exceeds a preset threshold; or a determination period expires.

Wherein, the determination period is a length of a time division multiplexing frame generated by the system.

Wherein, the forwarding module is further configured to:
forward the TDD time slot configuration to the BBU, which inserts the TDD time slot configuration into a media stream to transmit to the RRU.

With the above technical scheme, the number of symbols required in the time domain is calculated by the scheduling sub-system monitoring the number of the current users, and further the length of the time slots occupied by the downlink is obtained to control the working time of the power amplifiers, which not only satisfies the usage when the number of users is the maximum, but also works with the minimum power consumption when the number of users is zero or small.

### Brief Description of Drawings

Fig. 1 is a diagram of WIMAX system with a normal TDD control of power amplifiers;
Fig. 2 is a contrast diagram of TDD control of power amplifiers of the present document versus that of the original scheme in a WIMAX system;
Fig. 3 is a flowchart of corporation of a coarse adjustment scheme for TDD control of power amplifiers in a WIMAX system according to an embodiment in the present document; and
Fig. 4 is a flowchart of corporation of a fine adjustment scheme for TDD control of power amplifiers in a WIMAX system according to an embodiment in the present document.

### Preferred Embodiments of the Invention

In order to make the purpose, technical schemes and advantages of the present document more clear and apparent, the embodiments of the present document will be described in detail in conjunction with accompanying drawings hereinafter. It should be illustrated that, the embodiments in the present application and the features in the embodiments can be arbitrarily combined with each other.

The present document is suitable for a wireless TDD system, and in particular, for a Worldwide Interoperability for Microwave Access (WIMAX) system and a TDD Long Term Evolution (LTE) system.

### Embodiment one

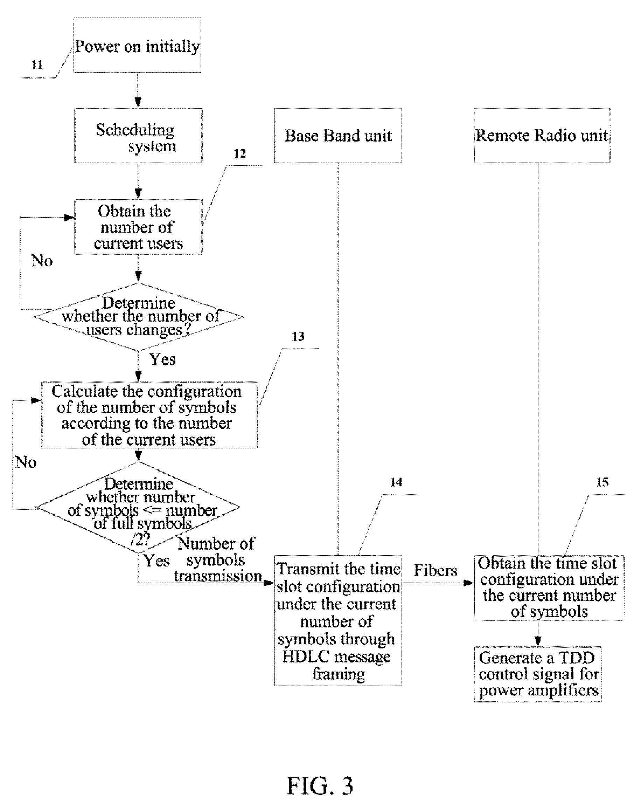

The application of the TDD system of a WIMAX distributed base station is used as an example in the present embodiment. In combination with Fig. 3, the specific process for a coarse adjustment scheme of a TDD system of a distributed base station, i.e., a Building Baseband Unit (BBU) + the RRU, is as follows:
In step 11, when the BBU is powered on initially, the BBU forwards message to the RRU according to the time slot configuration with the number of full symbols, and the RRU performs TDD control on the power amplifiers according to the time slot configuration.
In step 12, after the cell is established, a scheduling sub-system starts a real-time detection process, which detects the number of current users;
In step 13, a scheduling sub-system calculates the number of symbols required in the time domain according to the number of the current users, determines the time slot configuration according to the number of symbols required in the time domain, and forwards the time slot configuration to the BBU.

From 0 to the number of full symbols, it is to divide into at least two thresholds ranges;
the threshold range where the number of symbols required in the time domain is located is determined, the TDD time slot configuration corresponding to the threshold range is used as a finally determined TDD time slot configuration and is forwarded to a BBU, wherein, the TDD time slot configuration corresponding to the threshold range is not less than a TDD time slot configuration corresponding to the maximum number of symbols in the threshold range.

For example, the threshold range can be [0, ceil (the number of full symbols/2)] and [ceil (the number of full symbols/2), the number of full symbols], and
when ceil (the number of full symbols/2) ≤the number of symbols required in the time domain≤the number of full symbols, the time slot configuration under the number of full symbols is forwarded to the BBU;
when the number of symbols required in the time domain≤ceil (the number of full symbols/2), the time slot configuration under the ceil (the number of full symbols/2) is forwarded to the BBU;
wherein, ceil represents an operation of rounding up to an integer.

The 31:15 symbols configuration of the WIMAX system (i.e., 31 symbols for the downlink and 15 symbols for the uplink) is used as an example for illustration, and when 16 ≤the number of symbols required in the time domain≤31 is satisfied, the time slot configuration of 31 downlink symbols is forwarded to the BBU; and when the number of symbols required in the time domain<16 is satisfied, the time slot configuration of 16 downlink symbols is forwarded to the BBU

The above threshold range is only an example, and multiple threshold ranges can be set as required, for example, three or four threshold ranges.

Wherein, before the scheduling system calculates the number of symbols required in the time domain according to the number of the users in the cell, whether a triggering condition is satisfied is determined, and only if the triggering condition is satisfied, the number of symbols required in the time domain is calculated according to the number of the users in the cell. The triggering condition is that the number of the users in the cell changes, or the amplitude of the change of the number of the users in the cell exceeds the preset threshold.

In step 14, the BBU transmits the time slot configuration to the RRU through a High-Level Data Link Control (HDLC) signaling channel.

In step 15, when a timing signal comes, the RRU generates a new TDD control signal for reception and transmission time slots according to the changed time slot configuration.

### Embodiment two

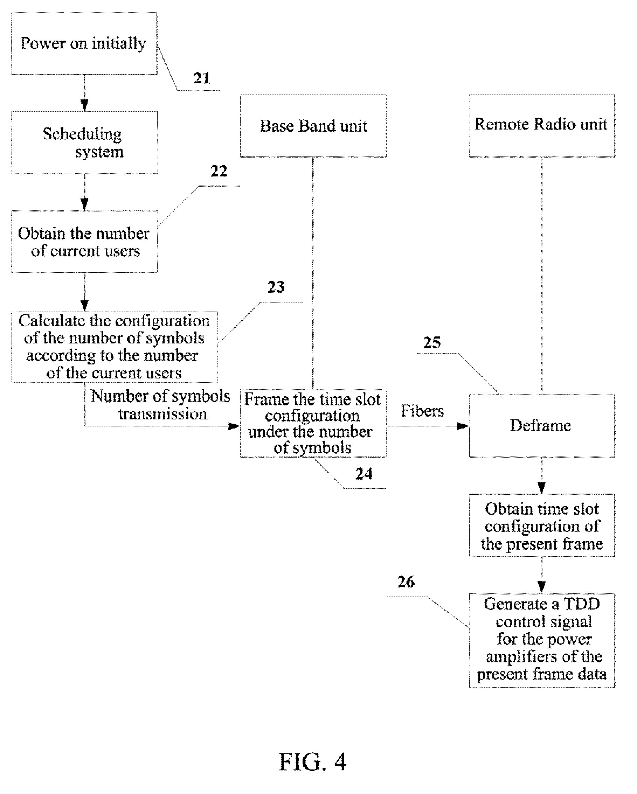

In combination with Fig. 4, the specific process for the fine adjustment scheme of the TDD system of BBU+RRU distributed base station is as follows:
In step 21, when the BBU is powered on initially, the BBU forwards message to the RRU according to the time slot configuration with a number of full symbols, and the RRU performs TDD control on the power amplifiers according to the time slot configuration;
in step 22, after the cell is established, a scheduling sub-system starts a real-time detection process, which detects the number of current users;
in step 23, when a determination period expires, a scheduling sub-system calculates the number of symbols required in the time domain according to the number of the detected users, determines the TDD time slot configuration, and transmits the configuration to the BBU;
   the time slot configuration here is the TDD time slot configuration actually corresponding to the number of symbols required in the time domain;
   in the present embodiment, the determination period is the length of the time division multiplexing frame generated by the system, and the determination period can also be the length of K time division multiplexing frames, wherein, K is a natural number and can be set as required, or the determination period can also be other values.
In step 24, the BBU inserts the TDD time slot configuration information into the media streams, and transmits the information to the RRU through fibers after framing.
In step 25, the RRU obtains the TDD time slot configuration of the present frame after deframing.
In step 26, when a timing signal comes, the RRU generates a new TDD control signal for reception and transmission time slots according to the changed TDD time slot configuration of the present frame.

The WIMAX distributed base station uses a PULSE PER 2 SECOND (PP2S) as a timing signal, with the time interval of each frame being 5 milliseconds.

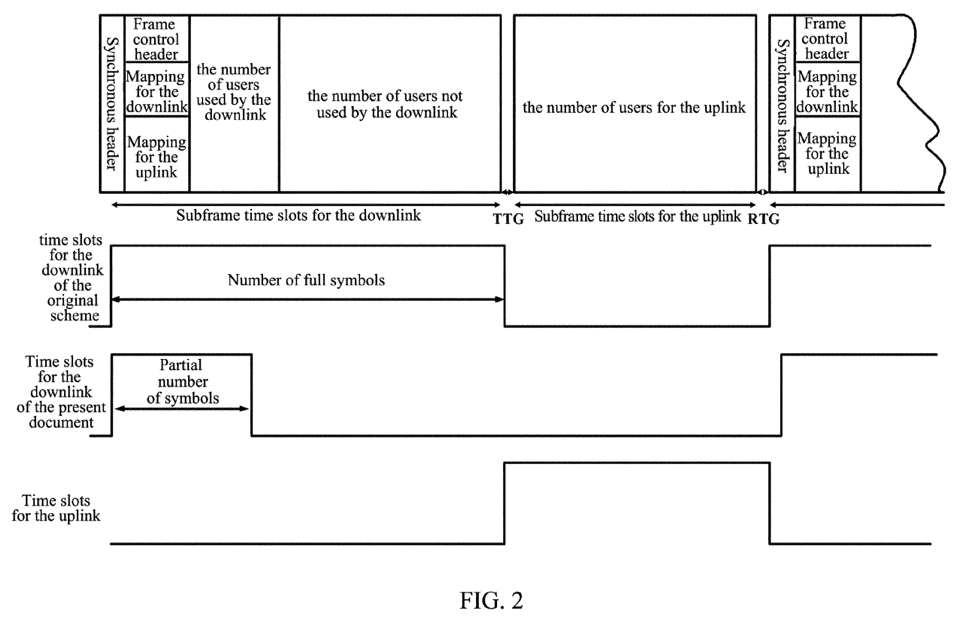

It can be seen from Fig. 2 that, the TDD of the power amplifiers which is adjusted according to the number of users is shorter than the TDD of the number of full symbols configuration, which effectively reduces the power consumption of the power amplifiers.

Some features of embodiments one and two can be combined, for example, in embodiment one, the RRU can also transmit the TDD time slot configuration to the BBU through the media streams, and in embodiment two, the final TDD time slot configuration can also be determined according to the preset threshold range when the time slot configuration is determined according to the number of symbols required in the time domain. In the case of no conflict, the features of embodiments one and two can be combined arbitrarily.

The use of the above two schemes to generate a TDD control signal of the power amplifiers effectively reduces the power consumption of the power amplifiers, thus enhancing the working efficiency of the power amplifiers.

It can be known from the contrastive analysis of the above coarse adjustment and fine adjustment schemes that, for the TDD system of the distributed base station, i.e., BBU+RRU, the coarse adjustment scheme uses a Medium Access Control (MAC) of the scheduling sub-system to schedule a task start real-time detection process, and uses the existing HDLC channel to transmit the time slot configuration parameters in real time, which is relatively easy to implement, and can reduce the power consumption of the power amplifiers. The fine adjustment scheme is to control each frame of data, and therefore requires a faster transmission of the time slot configuration message, and the time slot configuration message is transmitted through a media stream of the underlying layer, and therefore, the scheduling and the implementation of the underlying link is relatively complex to implement, but the control is accurate, and can reduce the power consumption of the power amplifiers to the maximum extent.

For the TDD integrated base station, the both schemes are simple to implement, after calculating the number of symbols, the scheduling sub-system transmits it to the BBU, and the TDD control signal of the power amplifiers is generated directly by the BBU according to the number of symbols configuration in real time, which reduces the transmission between the BBU and the RRU, and the fine adjustment scheme has more advantages for the integrated base station.

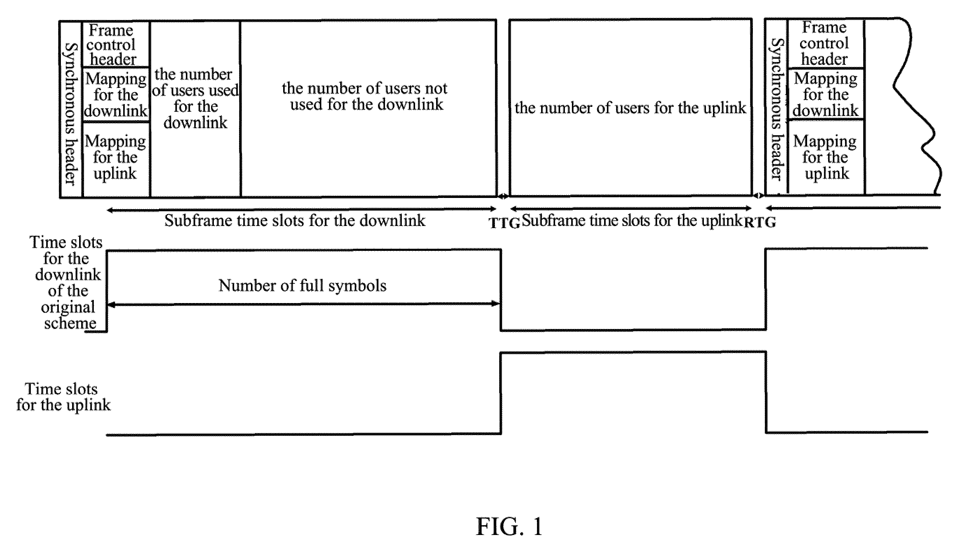

With respect to Figs. 1 and 2, the TTG in Figs. 1 and 2 represents an interval period for switching from a downlink subframe to an uplink subframe, and RTG represents an interval period for switching from an uplink subframe to a downlink subframe. For example, when the number of users is the maximum, the efficiency of the power amplifiers is 30%, and when there are 1/3 users, the efficiency of the power amplifiers becomes 18%, while using the method according to present document can make the efficiency of the power amplifiers still be equivalent to 30% when there are 1/3 users.

The method according to the present document can effectively reduce the power consumption of the power amplifiers, so that the efficiencies of the TDD system are equivalent both in cases of multiple users and less users, and in addition, the present document brings benefits to the heat dissipation of the system.

A system for reducing power consumption in a TDD system in embodiments of the present document comprises: a calculation module, a configuration module, and a forwarding module, wherein,
the calculation module is configured to calculate the number of symbols required in time domain according to the number of users in a cell;
the configuration module is configured to determine a TDD time slot configuration according to the number of symbols required in the time domain; and
the forwarding module is configured to forward the TDD time slot configuration to a RRU through a BBU.

Wherein, the configuration module is configured to determine the TDD time slot configuration by the following way:
from 0 to the number of full symbols, dividing into at least two threshold ranges; and determining a threshold range where the number of symbols required in the time domain is located, using the TDD time slot configuration corresponding to the threshold range as a finally determined TDD time slot configuration, wherein the TDD time slot configuration corresponding to the threshold range is not less than a TDD time slot configuration corresponding to the maximum number of symbols in the threshold range.

Wherein, the configuration module is configured to determine the TDD time slot configuration by the following way:
using the TDD time slot configuration corresponding to the number of symbols required in the time domain as a finally determined TDD time slot configuration.

The system further comprises: a determination module,
wherein, the configuration module is configured to: before calculating the number of symbols required in the time domain according to the number of users in a cell, determine whether a triggering condition is satisfied, and if it is satisfied, notify the calculation module to calculate the number of symbols required in the time domain according to the number of users in the cell.

The triggering condition is that:
the number of users in the cell changes; or
an amplitude of the change of the number of users in the cell exceeds a preset threshold; or a determination period expires.

Wherein, the determination period is the length of a time division multiplexing frame generated by the system.

Wherein, the forwarding module is further configured to:
forward the TDD time slot configuration to the BBU, which inserts the TDD time slot configuration into a media stream to transmit to the RRU.

A person having ordinary skill in the art can understand that all or a part of steps in the above method can be implemented by programs instructing related hardware, and the programs can be stored in a computer readable storage medium, such as a read-only memory, disc or disk etc. Alternatively, all or a part of steps in the above embodiments can also be implemented by one or more integrated circuits. Accordingly, each module/unit in the above embodiments can be implemented in a form of hardware, or can also be implemented in a form of software functional module. The present document is not limited to any particular form of a combination of hardware and software.

The above embodiments are only used to illustrate the technical schemes of the present document and are not intended to be limitation, and the present document is merely illustrated in detail with respect to preferable embodiments. Those of ordinary skill in the art should understand that modifications or equivalent substitutions can be made on the technical schemes of the present document without departing from the spirit and scope of the technical schemes of the present document, all of which should be contained in the scope of the claims of the present document.

### Industrial Applicability

With the above technical scheme, the number of symbols required in the time domain is calculated by the scheduling sub-system monitoring the number of the current users, and further the length of the time slots occupied by the downlink is obtained to control the working time of the power amplifiers, which not only satisfies the usage when the number of users is the maximum, but also works with the minimum power consumption when the number of users is zero or small. Therefore, the present document is with very powerful industrial applicability.

## Claims

1. A method for reducing power consumption in a Time Division Duplex (TDD) system, said system including a Baseband Unit (BBU) and a number of power amplifiers, **characterized in that** the method comprises:
- a scheduling system calculating (13, 23) a number of symbols required in time domain according to a number of current users in a cell;
- determining (13, 23) a TDD time slot configuration according to the number of symbols required in time domain;
- forwarding (13, 14; 23, 24) the TDD time slot configuration to the BBU; and
- the BBU generating (15, 26) a TDD control signal to the power amplifiers for controlling the working time of the power amplifiers according to the TDD time slot configuration, whereby the power consumption of the TDD system is reduced;
wherein the step of determining (13, 23) the TDD time slot configuration according to the number of symbols required in time domain comprises either a coarse adjustment scheme or a fine adjustment scheme;
wherein the coarse adjustment scheme includes:
- dividing a range spanning from 0 to a number of full symbols into at least two sub-ranges;
- determining the sub-range in which the number of symbols required in time domain fall;
- using the TDD time slot configuration corresponding to the maximum number of symbols in the sub-range;
wherein the fine adjustment scheme includes:
- using the TDD time slot configuration corresponding to the actual number of symbols required in time domain.

2. The method according to claim 1, wherein the method further comprises prior to the step of the scheduling system calculating (13, 23) the number of symbols required in time domain according to the number of current users in a cell:
- determining whether a triggering condition is satisfied; and
- if the triggering condition is satisfied, calculating the number of symbols required in time domain according to the number of current users in the cell.

3. The method according to claim 2, wherein the triggering condition comprises:
- a change in the number of current users in the cell; or
- the magnitude of the change in the number of current users in the cell exceeding a preset threshold; or
- the expiration of a determination period.

4. The method according to claim 3, wherein the determination period is the length of a time division multiplexing frame generated by the system.

5. The method according to any of the preceding claims, wherein the method further comprises the BBU inserting (13, 24) the TDD time slot configuration into a media stream and the BBU transmitting the media stream to a Remote Radio Unit (RRU).

6. A system for reducing power consumption in a Time Division Duplex (TDD) system, said system including a Baseband Unit (BBU) and a number of power amplifiers, **characterized in that** the system further includes a calculation module, a configuration module and a forwarding module, the calculation module being configured to calculate a number of symbols required in time domain according to a number of current users in a cell, the configuration module being configured to determine a TDD time slot configuration according to the number of symbols required in time domain, the forwarding module being configured to forward the TDD time slot configuration to the BBU, which BBU is adapted to generate a TDD control signal to the power amplifiers for controlling the working time of the power amplifiers according to the TDD time slot configuration, whereby the power consumption of the TDD system is reduced, wherein the configuration module is further configured to determine the TDD time slot configuration according to the number of symbols required in time domain by either a coarse adjustment scheme or a fine adjustment scheme, wherein, under the coarse adjustment scheme, the configuration module is adapted to divide a range spanning from 0 to a number of full symbols into at least two sub-ranges, to determine the sub-range in which the number of symbols required in time domain fall and to use the TDD time slot configuration corresponding to the maximum number of symbols in the sub-range, wherein, under the fine adjustment scheme, the configuration module is adapted to use the TDD time slot configuration corresponding to the actual number of symbols required in time domain.

7. The system according to claim 6, wherein the system further comprises a determination module configured to determine whether a triggering condition is satisfied and, if the triggering condition is satisfied, to notify the calculation module prior to calculate the number of symbols required in time domain according to the number of current users in the cell.

8. The system according to claim 7, wherein, the triggering condition comprises:
- the change in the number of current users in the cell; or
- the magnitude of the change in the number of current users in the cell exceeding a preset threshold; or
- the expiration of a determination period.

9. The system according to claim 8, wherein the determination period is the length of a time division multiplexing frame generated by the system.

10. The system according to any of the preceding claims, wherein the BBU is further adapted to insert the TDD time slot configuration into a media stream and to transmit the media stream to a Remote Radio Unit (RRU).

## Patentansprüche

1. Verfahren zur Reduzierung der Verlustleistung in einem Zeitmultiplex-Dualsystem (TDD), wobei das System eine Basisbandeinheit (BBU) und eine Anzahl von Leistungsverstärkern umfasst, **dadurch gekennzeichnet, dass** das Verfahren Folgendes umfasst:
- ein Ablaufsystem, das eine Anzahl von Symbolen berechnet (13, 23), die in der Zeitdomäne entsprechend einer Anzahl derzeitiger Nutzer in einer Zelle erforderlich sind;
- Bestimmen (13, 23) einer TDD-Zeitfensterkonfiguration entsprechend der Anzahl von Symbolen, die in der Zeitdomäne erforderlich sind;
- Weiterleiten (13, 14; 23, 24) der TDD-Zeitfensterkonfiguration an die BBU; und
- Erzeugen (15, 26) seitens der BBU eines TDD-Steuersignals für die Leistungsverstärker zur Steuerung der Arbeitszeit der Leistungsverstärker gemäß der TDD-Zeitfensterkonfiguration, wodurch die Verlustleistung des TDD-Systems verringert wird; wobei der Schritt des Bestimmens (13, 23) der TDD-Zeitfensterkonfiguration gemäß der Anzahl von Symbolen, die in der Zeitdomäne erforderlich sind, entweder ein grobes Anpassungsschema oder ein feines Anpassungsschema umfasst;
wobei das grobe Anpassungsschema Folgendes umfasst:
- Teilen eines Bereichs von 0 bis zu einer Anzahl der gesamten Symbole in mindestens zwei Unterbereiche;
- Bestimmung des Unterbereichs, in dem die Anzahl von Symbolen, die in der Zeitdomäne erforderlich sind, fällt;
- Verwenden der TDD-Zeitfensterkonfiguration entsprechend der maximalen Anzahl von Symbolen in dem Unterbereich;
wobei das feine Anpassungsschema Folgendes umfasst:
- Verwenden der TDD-Zeitfensterkonfiguration entsprechend der tatsächlichen Anzahl von Symbolen, die in der Zeitdomäne erforderlich sind.

2. Verfahren gemäß Anspruch 1, wobei das Verfahren ferner vor dem Schritt des Ablaufsystems, das eine Anzahl von Symbolen berechnet (13, 23), die in der Zeitdomäne entsprechend der Anzahl derzeitiger Nutzer in einer Zelle erforderlich sind, Folgendes umfasst:
- Bestimmen, ob eine Auslösebedingung erfüllt ist; und
- wenn die Auslösebedingung erfüllt ist, Berechnen der Anzahl von Symbolen, die in der Zeitdomäne entsprechend der Anzahl derzeitiger Nutzer in der Zelle erforderlich sind.

3. Verfahren gemäß Anspruch 2, wobei die Auslösebedingung Folgendes umfasst:
- eine Veränderung der Anzahl derzeitiger Nutzer in der Zelle; oder
- das Ausmaß der Veränderung der Anzahl derzeitiger Nutzer in der Zelle übersteigt einen voreingestellten Schwellenwert; oder
- den Ablauf eines Bestimmungszeitraumes.

4. Verfahren gemäß Anspruch 3, wobei der Bestimmungszeitraum die Länge eines vom System erzeugten Zeitmultiplexrahmens ist.

5. Verfahren gemäß einem der vorhergehenden Ansprüche, wobei das Verfahren ferner umfasst, dass die BBU die TDD-Zeitfensterkonfiguration in einen Medienstrom einspeist (13, 24) und die BBU den Medienstrom an eine Fernfunkeinheit (RRU) überträgt.

6. System zur Reduzierung der Verlustleistung in einem Zeitmultiplex-Dualsystem (TDD), wobei dieses System eine Basisbandeinheit (BBU) und eine Anzahl von Leistungsverstärkern umfasst, **dadurch gekennzeichnet, dass** das System ferner ein Berechnungsmodul, ein Konfigurationsmodul und ein Weiterleitungsmodul umfasst, wobei das Berechnungsmodul so konfiguriert ist, dass es eine Anzahl von Symbolen berechnet, die in der Zeitdomäne entsprechend einer Anzahl derzeitiger Nutzer in einer Zelle erforderlich sind, wobei das Konfigurationsmodul so konfiguriert ist, dass es eine TDD-Zeitfensterkonfiguration entsprechend der Anzahl von Symbolen, die in der Zeitdomäne erforderlich sind, bestimmt, wobei das Weiterleitungsmodul so konfiguriert ist, dass es die TDD-Zeitfensterkonfiguration an die BBU weiterleitet, wobei die BBU dafür angepasst ist, ein TDD-Steuersignal für die Leistungsverstärker zur Steuerung der Arbeitszeit der Leistungsverstärker gemäß der TDD-Zeitfensterkonfiguration zu erzeugen, wodurch die Verlustleistung des TDD-Systems verringert wird, und wobei das Konfigurationsmodul ferner so konfiguriert ist, dass es die TDD-Zeitfensterkonfiguration gemäß der Anzahl von Symbolen, die in der Zeitdomäne erforderlich sind, entweder anhand eines groben Anpassungsschemas oder anhand eines feinen Anpassungsschemas bestimmt, wobei das Konfigurationsmodul im groben Anpassungsschema angepasst ist, einen Bereich von 0 bis zu einer Anzahl der gesamten Symbole in mindestens zwei Unterbereiche zu teilen, den Unterbereich, in den die Anzahl von Symbolen, die in der Zeitdomäne erforderlich sind, fällt, zu bestimmen und die TDD-Zeitfensterkonfiguration entsprechend der maximalen Anzahl von Symbolen in dem Unterbereich zu verwenden, und wobei das Konfigurationsmodul im feinen Anpassungsschema angepasst ist, die TDD-Zeitfensterkonfiguration entsprechend der tatsächlichen Anzahl von Symbolen, die in der Zeitdomäne erforderlich sind, zu verwenden.

7. System gemäß Anspruch 6, wobei das System ferner ein Bestimmungsmodul umfasst, das so konfiguriert ist, dass es bestimmt, ob eine Auslösebedingung erfüllt ist, und wenn die Auslösebedingung erfüllt ist, das Berechnungsmodul benachrichtigt, ehe es die Anzahl von Symbolen berechnet, die in der Zeitdomäne entsprechend der Anzahl derzeitiger Nutzer in der Zelle erforderlich sind.

8. System gemäß Anspruch 7, wobei die Auslösebedingung Folgendes umfasst:
- eine Veränderung der Anzahl derzeitiger Nutzer in der Zelle; oder
- das Ausmaß der Veränderung der Anzahl derzeitiger Nutzer in der Zelle übersteigt einen voreingestellten Schwellenwert; oder
- den Ablauf eines Bestimmungszeitraumes.

9. System gemäß Anspruch 8, wobei der Bestimmungszeitraum die Länge eines vom System erzeugten Zeitmultiplexrahmens ist.

10. System gemäß einem der vorhergehenden Ansprüche, wobei die BBU ferner geeignet ist, die TDD-Zeitfensterkonfiguration in einen Medienstrom einzuspeisen und den Medienstrom an eine Fernfunkeinheit (RRU) zu übertragen.

## Revendications

1. Procédé de réduction de la consommation de puissance dans un système duplex par répartition dans le temps (TDD), ledit système comprenant une unité de bande de base (BBU) et une pluralité d'amplificateurs de puissance, **caractérisé en ce que** le procédé comprend :
- le calcul par un système de planification (13, 23) d'un nombre de symboles nécessaire dans le domaine temporel en fonction d'un nombre d'utilisateurs actuels dans une cellule ;
- la détermination (13, 23) d'une configuration de créneaux TDD en fonction du nombre de symboles nécessaire dans le domaine temporel ;
- la transmission (13, 14 ; 23, 24) de la configuration de créneaux TDD à la BBU ; et
- la génération par la BBU (15, 26) d'un signal de commande TDD pour les amplificateurs de puissance pour commander le temps de travail des amplificateurs de puissance en fonction de la configuration de créneaux TDD, moyennant quoi la consommation de puissance du système TDD est réduite ;
dans lequel l'étape de détermination (13, 23) de la configuration de créneaux TDD en fonction du nombre de symboles nécessaire dans le domaine temporel comprend l'un ou l'autre d'un schéma de réglage grossier ou d'un schéma de réglage fin ;
dans lequel le schéma de réglage grossier comprend :
- la division d'une plage s'étendant de 0 à un nombre de symboles complets en au moins deux sous-plages ;
- la détermination de la sous-plage dans laquelle le nombre de symboles nécessaire dans le domaine temporel se situe ;
- l'utilisation de la configuration de créneaux TDD correspondant au nombre maximum de symboles dans la sous-plage ;
dans lequel le schéma de réglage fin comprend :
- l'utilisation de la configuration de créneaux TDD correspondant au nombre réel de symboles nécessaire dans le domaine temporel.

2. Procédé selon la revendication 1, dans lequel le procédé comprend en outre, avant l'étape de calcul par un système de planification (13, 23) du nombre de symboles nécessaire dans le domaine temporel en fonction du nombre d'utilisateurs actuels dans une cellule :
- la détermination du fait qu'une condition de déclenchement est satisfaite ; et
- si la condition de déclenchement est satisfaite, le calcul du nombre de symboles nécessaire dans le domaine temporel en fonction du nombre d'utilisateurs actuels dans la cellule.

3. Procédé selon la revendication 2, dans lequel la condition de déclenchement comprend :
- un changement dans le nombre d'utilisateurs actuels dans la cellule ; ou
- la grandeur du changement dans le nombre d'utilisateurs actuels dans la cellule dépassant un seuil prédéfini ; ou
- l'expiration d'une période de détermination.

4. Procédé selon la revendication 3, dans lequel la période de détermination est la longueur d'une trame de multiplexage par répartition dans le temps générée par le système.

5. Procédé selon l'une quelconque des revendications précédentes, dans lequel le procédé comprend en outre l'insertion par la BBU (13, 24) de la configuration de créneaux TDD dans un flux de média et la transmission par la BBU du flux de média à une unité radio à distance (RRU).

6. Système de réduction de la consommation de puissance dans un système duplex par répartition dans le temps (TDD), ledit système comprenant une unité de bande de base (BBU) et une pluralité d'amplificateurs de puissance, **caractérisé en ce que** le système comprend en outre un module de calcul, un module de configuration et un module de transmission, le module de calcul étant configuré pour calculer un nombre de symboles nécessaire dans le domaine temporel en fonction d'un nombre d'utilisateurs actuels dans une cellule, le module de configuration étant configuré pour déterminer une configuration de créneaux TDD en fonction du nombre de symboles nécessaire dans le domaine temporel, le module de transmission étant configuré pour transmettre la configuration de créneaux TDD à la BBU, laquelle BBU est adaptée pour générer un signal de commande TDD pour les amplificateurs de puissance pour commander le temps de travail des amplificateurs de puissance en fonction de la configuration de créneaux TDD, moyennant quoi la consommation de puissance du système TDD est réduite, dans lequel le module de configuration est configuré en outre pour déterminer la configuration de créneaux TDD en fonction du nombre de symboles nécessaire dans le domaine temporel par l'un ou l'autre d'un schéma de réglage grossier ou d'un schéma de réglage fin, dans lequel, dans le cadre du schéma de réglage grossier, le module de configuration est adapté pour diviser une plage s'étendant de 0 à un nombre de symboles complets en au moins deux sous-plages, pour déterminer la sous-plage dans laquelle le nombre de symboles nécessaire dans le domaine temporel se situe et pour utiliser la configuration de créneaux TDD correspondant au nombre maximum de symboles dans la sous-plage, dans lequel, dans le cadre du schéma de réglage fin, le module de configuration est adapté pour utiliser la configuration de créneaux TDD correspondant au nombre réel de symboles nécessaire dans le domaine temporel.

7. Système selon la revendication 6, dans lequel le système comprend en outre un module de détermination configuré pour déterminer si une condition de déclenchement est satisfaite et, si la condition de déclenchement est satisfaite, pour aviser le module de calcul avant de calculer le nombre de symboles nécessaire dans le domaine temporel en fonction du nombre d'utilisateurs actuels dans la cellule.

8. Système selon la revendication 7, dans lequel la condition de déclenchement comprend :
- un changement dans le nombre d'utilisateurs actuels dans la cellule ; ou
- la grandeur du changement dans le nombre d'utilisateurs actuels dans la cellule dépassant un seuil prédéfini ; ou
- l'expiration d'une période de détermination.

9. Système selon la revendication 8, dans lequel la période de détermination est la longueur d'une trame de multiplexage par répartition dans le temps générée par le système.

10. Système selon l'une quelconque des revendications précédentes, dans lequel la BBU est adaptée en outre pour insérer la configuration de créneaux TDD dans un flux de média et transmettre le flux de média à une unité radio à distance (RRU).
